# EUROPEAN PATENT SPECIFICATION

(11) **EP 1 167 291 B1**
(45) Date of publication and mention of the grant of the patent: **26.10.2005**
(21) Application number: 01114805.3
(22) Date of filing: 27.06.2001
(51) Int. Cl.: C01B 21/064

(54) **Hexagonal boron nitride film with low dielectric constant, layer dielectric film and method of production thereof, and plasma CVD apparatus**
Hexagonal- Bornitrid-Film mit niedriger dielektrischer Konstante ,Film mit dielektrischer Beschichtung und Verfahren zu seiner Herstellung und Plasma-CVD-Apparat
Film en nitrure de bore hexagonal ayant une faible constante diélectrique ,revètement d' une couche dielectrique et méthode pour sa production et appareil à plasma de dépôt chimique en phase vapeur

(30) Priority: 28.06.2000 JP 2000193734; 09.03.2001 JP 2001067042; 18.04.2001 JP 2001120272
(43) Date of publication of application: 02.01.2002
(60) Divisional application: 03017567.3
(73) Proprietor: MITSUBISHI HEAVY INDUSTRIES, LTD., Tokyo 100-8315 (JP)
(72) Inventor: Sakamoto, Hitoshi, Mitsubishi Heavy Ind., Ltd., Kanazawa-ku, Yokohama, Kanagawa 236-8515 (JP); Nishimori, Toshihiko, Mitsubishi Heavy Ind., Ltd., Takasago, Hyogo-ken 676-8686 (JP); Sonobe, Hiroshi, Mitsubishi Heavy Ind., Ltd., Nagasaki, Nagasaki-ken 851-0392 (JP); Yonekura, Yoshimichi, Mitsubishi Heavy Ind., Ltd., Kanazawa-ku, Yokohama, Kanagawa 236-8515 (JP); Yamashita, Nobuki, Mitsubishi Heavy Ind., Ltd., Kanazawa-ku, Yokohama, Kanagawa 236-8515 (JP)
(74) Representative: HOFFMANN EITLE

(56) References cited:
- US-A- 5 324 690
- HYDER S B ET AL: "STRUCTURE AND PROPERTIES OF BORON NITRIDE FILMS GROWN BY HIGH TEMPERATURE REACTIVE PLASMA DEPOSITION" JOURNAL OF THE ELECTROCHEMICAL SOCIETY, ELECTROCHEMICAL SOCIETY. MANCHESTER, NEW HAMPSHIRE, US, vol. 123, no. 11, November 1976 (1976-11), pages 1721-1724, XP001024714 ISSN: 0013-4651
- NGUYEN S V ET AL: "PLASMA-ASSISTED CHEMICAL VAPOR DEPOSITION AND CHARACTERIZATION OF BORON NITRIDE FILMS" JOURNAL OF THE ELECTROCHEMICAL SOCIETY, ELECTROCHEMICAL SOCIETY. MANCHESTER, NEW HAMPSHIRE, US, vol. 141, no. 6, June 1994 (1994-06), pages 1633-1638, XP001024715 ISSN: 0013-4651
- GELATOS A. V. ET AL: "THE PROPERTIES OF A PLASMA DEPOSIED CANDIDATE INSULATOR FOR FUTURE MULTILEVEL INTERCONNECTS TECHNOLOGY" MATERIALS RESEARCH SOCIETY SYMPOSIUM PROCEEDINGS , vol. 260, 1992, pages 347-354, XP000926647 ISSN: 0272-9172
- SUGINO T ET AL: "DIELECTRIC CONSTANT OF BORON NITRIDE FILMS SYNTHESIZED BY PLASMA-ASSISTED CHEMICAL VAPOR DEPOSITION" JAPANESE JOURNAL OF APPLIED PHYSICS, PUBLICATION OFFICE JAPANESE JOURNAL OF APPLIED PHYSICS. TOKYO, JP, vol. 39, no. 11A, PART 2, November 2000 (2000-11), pages L1101-L1104, XP001031904 ISSN: 0021-4922

## Description

### FIELD OF THE INVENTION

The present invention relates to a boron nitride film which can be utilized as a layer dielectric film material with low dielectric constant and to a method of the production thereof.

### BACKGROUND OF THE INVENTION

Silicon oxide films (specific inductance ε = 4 to 4.5) have been widely used as the layer dielectric film in integrated circuits so far. However, wiring delay is a factor governing device signal delay in the case of aiming at high integration in the next generation. To improve this situation, it is necessary to make the dielectric constant of the layer dielectric film low. Since the specific inductance is high, the silicon oxide films cannot be used in integrated circuits in the next generation. There are needs for layer dielectric film materials having a lower dielectric constant. In this situation, although there are materials having a very low, less than 2.5, dielectric constant ε among organic type materials, these materials have the problem of inferior heat resistance. Therefore, boron nitride (BN) having a specific inductance of the order of that of a silicon oxide film has been remarked and an attempt to decrease the dielectric constant of boron nitride has been made.

Conventionally, a plasma CVD method is usually used for the formation of a BN thin film. However, this method has the following problem. Specifically, because, for instance, diborane (B₂H₆) and ammonia (NH₃) are used as the source gas, hydrogen bonds such as BH and NH are generated in the BN film, so that a specific inductance as low as 3.0 or less cannot be achieved and a substrate temperature as relatively high as 400 °C is required in the formation of a thin film of cubic BN (hereinafter referred to as "c-BN") or hexagonal BN (hereinafter referred to as "h-BN"), which causes deterioration of metal wirings due to heat. Therefore, this method cannot be applied to a process for producing metal wirings.

US 5,324,690 relates to the formation of non-silyated ternary boron nitride films used for semiconductor device applications. For example, boron oxynitride (BNO) is deposited in a plasma-enhanced chemical vapor deposition reactor using ammonia (NH₃), diborane (B₂H₆), and nitrous oxide (N₂O).

Hyder et al. describe boron nitride films produced by reacting ammonia and diborane (J. Electrochem. Soc.: Solid-State Science and Technology, 1976, pages 1721-1724).

Nguyen et al. disclose boron nitride films which were deposited in the single-wafer plasma enhanced chemical vapor deposition (PECVD) system using two different reactant gas chemistries: (i) dilute diborane, nitrogen and ammonia; (ii) borazine (B₃N₃H₆) and nitrogen as precursor materials (J. Electrochem. Soc., Vol. 141, No. 6, June 1994, pages 1633-1638).

Gelatos et al. disclose the formation of a boron nitride film using ammonia and diborane. Furthermore, it is described that the main parameters affecting the dielectric constant are the ratio of ammonia to diborane flow and the deposition temperature (Mat. Res. Soc. Symp. Proc. Vol. 260, 1992, pages 347-354).

In the meantime, as layer dielectric films having a low specific inductance (specific inductance = 2.0 to 2.7) in semiconductor devices, organic films (Flare, SiLK: polyallyl ether type polymer, BCB: benzocyclobutene type polymer) and organic or inorganic hybrid films (HSG-R7: methylsiloxane type SOG, HOSP: hydrogenated methylsilsesquioxane) produced by a rotary coating method and organic films (α-CF: fluorinated hydrocarbon type polymer, AF4: fluorinated valerin type polymer) and organic or inorganic hybrid films (Black Diamond: methyl silane type, 4MS: tetramethylsilane type) produced by a CVD method have been developed and in addition, studies are being made concerning porous film structures.

As aforementioned, since the density of conventional layer dielectric films having a low specific inductance are made low to decrease the specific inductance, the conventional dielectric film poses the problems such as reduced resistance to oxygen plasma, inferior mechanical strength, reduced thermal diffusion efficiency, increased moisture-absorption and permeation ability, reduced heat resistance and reduced barrier effects against diffusion of impurities. Therefore, the conventional dielectric film has the problems of the possibility of a significant reduction in device characteristics in processes such as heat treatment and CMP (Chemical Mechanical Polishing) after the layer dielectric film having a low specific inductance is formed.

### SUMMARY OF THE INVENTION

It is an object of the present invention to provide a hexagonal boron nitride film having a specific inductance of 3.0 or less and also to provide a method of producing a layer dielectric film at low temperatures where metal wirings are not deteriorated by heat.

In a hexagonal boron nitride film having a low dielectric constant, a layer dielectric film and a method of producing these films according to the present invention, there is provided a hexagonal boron nitride film having a specific inductance of 3.0 or less. There are also provided a hexagonal boron nitride film in which the total content of the bonds between a nitrogen atom and a hydrogen atom and between a boron atom and a hydrogen atom is 4 mol% or less, a hexagonal boron nitride film in which a spacing in the c-axis direction is extended by 5 to 30% from 3.3 angstroms but the extension of a spacing in the a-axis direction is limited within 5% from 2.2 angstroms and a hexagonal boron nitride film in which the direction of the c-axis is parallel to a substrate. There is also provided a layer dielectric film using each of these hexagonal boron nitride films. Also, in a method of producing a hexagonal boron nitride film by using an ion deposition method involving the radiation of a mixed ion consisting of a nitrogen ion or nitrogen and rare gas and the deposition of a boron supply source under vacuum, there is provided a method of producing a hexagonal boron nitride film, the method comprising using raw gas containing no bond with a hydrogen atom.

Moreover, the plasma CVD apparatus used in the present invention comprises a film forming unit which forms a film having a low specific inductance as a protective film on the surface of an inter-wiring dielectric film formed on a semiconductor wafer and having a low specific inductance and a heating unit which heats the semiconductor wafer to a predetermined temperature. According to this invention, the film having a low specific inductance is formed by the film forming unit on the surface of the inter-wiring dielectric film and thereafter the semiconductor wafer is heated to form the protective film on the surface of the inter-wiring dielectric film and therefore resistance to oxygen plasma, mechanical strength, thermal diffusion efficiency, moisture absorption and permeation ability, heat resistance and barrier effects against the diffusion of impurities can be improved over those of plasma CVD apparatuses currently in use. Also, according to the present invention, the formation of the film having a low specific inductance capacity and heat treatment are carried out continuously, enabling the shortening of the process.

The plasma CVD apparatus used in the present invention comprises a first film forming unit which forms an inter-wiring film having a low specific inductance on the surface of the semiconductor wafer, a second film forming unit which forms a film having a low specific inductance as a protective film on the surface of the inter-wiring dielectric film and a heating unit which heats the semiconductor wafer to a predetermined temperature. According to this invention, the formation of the inter-wiring dielectric film and the formation of the protective film are continuously carried out, enabling further shortening of the process.

Also, the plasma CVD apparatus further comprises a porosity-promoting unit which makes the inter-wiring dielectric film porous. According to this invention, because the porosity of the inter-wiring dielectric film is increased by the porosity-promoting unit and the protective film is formed on the surface of the inter-wiring dielectric film, the process can be shortened. Moreover, the interface characteristics which are weak points of a porous film can be improved and also the deterioration in film qualities and an increase in moisture absorption ability caused by filming, etching and ashing can be limited.

Other objects and features of this invention will become apparent from the following description with reference to the accompanying drawings.

### BRIEF DESCRIPTION OF THE DRAWINGS

Fig. 1 is a view showing an example of an integrated circuit element containing a layer dielectric film;
Fig. 2 is a view showing a conventional h-BN film, and Fig. 2B is a view showing h-BN film according to the present invention;
Fig. 3 is a view showing a filming apparatus using an ion deposition method and used in the present invention;
Fig. 4 shows the results of measurements of the infrared absorption spectral (FTIR) of an h-BN film prepared in a first embodiment, wherein the region A shows a region where a peak based on an NH bond appears and the region B shows a region where a peak based on a BH bond appears;
Fig. 5 is a view showing the structure of a plasma CVD apparatus used in the present invention;
Fig. 6 is a view showing the structure of a semiconductor device produced in the present invention;
Fig. 7 is a flowchart showing a production process according to the present invention;
Fig. 8 is a flowchart showing a production process according to the present invention; and
Fig. 9 is a flowchart showing a production process according to the present invention.

### DESCRIPTION OF THE PREFERRED EMBODIMENTS

Preferred embodiments of the present invention are described below with reference to accompanying drawings.

The h-BN film according to the present invention can be utilized as an layer dielectric film having a low dielectric constant.

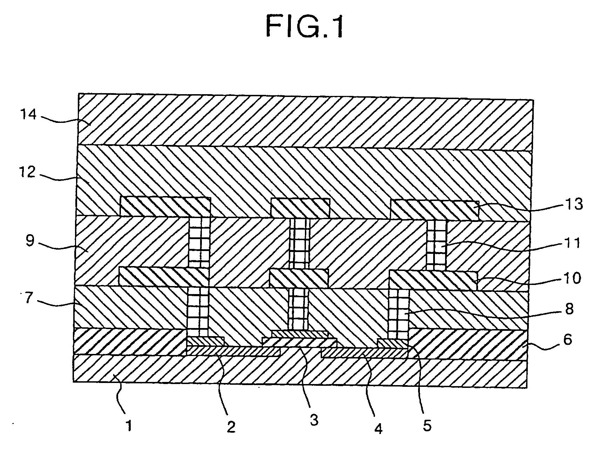

The layer dielectric film means a dielectric film and a protective film which are included in an integrated circuit device and electrically isolate electrodes, plugs and wirings formed on a substrate. The layer dielectric film includes, for example, a device dielectric film. An example of an integrated circuit device is shown in Fig. 1. Here, the wiring section is structured of two layers.

The substrate 1 such as a silicon substrate is provided with, for instance, the source 2, gate oxide film 3, drain 4, electrode 5 and dielectric film 6 and on the dielectric film, device dielectric film 7 (structured of, for example, a silicon oxide film) is formed. The device dielectric film 7 is provided with a first layer dielectric film 9 having a wiring section 10 connected to a contact plug 8 of the device dielectric film 7 . The second layer dielectric film 12 is provided on the layer dielectric film 9. The wiring section 10 in the second layer dielectric film 9 is connected to a wiring section 13 in the second layer dielectric film 12 through a via-plug 11. The second layer dielectric film 12 is protected by an end protective film 14. The terminal protective film 14 is usually constituted of a silicon nitride or the like.

The h-BN layer dielectric film of the present invention has a film thickness of preferably 0.1 to 1.0 µm and more preferably 0.35 µm (3,500 angstrom). The layer dielectric film according to the present invention is a type obtained by lowering the dielectric constant of a conventional layer dielectric film. However, the layer dielectric film according to the present invention may be used like the conventional layer dielectric film and may also be used, for example, as a substrate, a device dielectric film and an end protective film which are conventionally used. As the wiring metals, copper or an aluminum alloy may be used as usual.

According to 0.18 µm design rule, wiring delay when aluminum alloy is used for a wiring material and SiO₂ (specific inductance: 4.5) is used as a layer dielectric material is 18 ps (see, for example, "LATEST TREND OF SEMICONDUCTOR PERIPHERAL MATERIALS" (1999) p19, Toray Research Center). When the h-BN according to the present invention is used as a layer dielectric film, a higher operation speed can be expected and the wiring delay in this case is considered to be close to about 10 ps which is a wiring delay obtained when copper is used as a wiring material and an insulating material having a low dielectric constant as a layer insulting material.

The h-BN film according to the present invention is characterized by having reduced number of bonds (NH) between nitrogen atom and hydrogen atom and bonds (BH) between boron atom and hydrogen atom. The number of hydrogen bonds can be found by the Fourier-transform infrared absorption spectroscopic method (FTIR) and is limited to 4 mol% or less and preferably 0.1 mol% or less in the h-BN film. Reduction in the number of hydrogen bonds such as BH and NH makes it possible to attain a low dielectric constant, specifically, a specific inductance as low as 3.0 or less.

Also, the h-BN film according to the present invention is characterized by having a spacing extending in the c-axis direction. The spacing can be measured by X-ray diffraction method (XRD) or using transmission type electron microscope (TEM) (see, for example, JCPDS card No. 34-421). The spacing of a general h-BN is 3.3 angstroms in the c-axis direction, 2.2 angstroms in the a-axis direction and 2.2 angstroms in the b-axis direction. Compared with the spacing of the general h-BN, the spacing of the h-BN according to the present invention is extended in the c-axis direction by preferably 5 to 30%, more preferably 10 to 20% and particularly preferably 15% and in the a-axis direction by preferably 5% or less and more preferably 3% or less. It is considered that if the spacing is extended in the c-axis direction, the density of the h-BN film is decreased and therefore the dielectric constant is decreased.

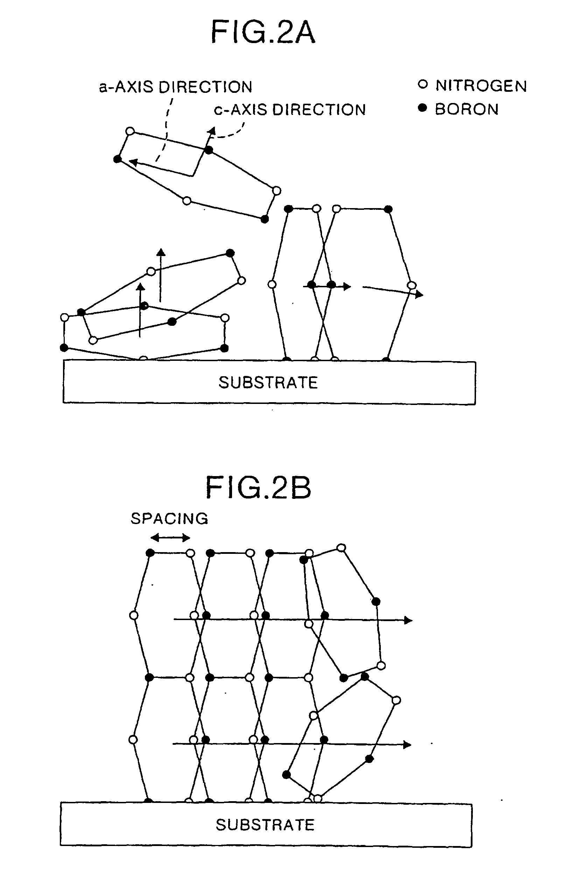

The h-BN film according to the present invention is characterized by having the c-axis extending in a direction parallel to the substrate. Fig. 2A shows a conventional h-BN film and Fig. 2B shows the h-BN film according to the present invention. Although the conventional h-BN film is hexagonal, the direction of orientation is random and therefore the h-BN film is nearly amorphous. On the other hand, the h-BN film according to the present invention is a hexagonal system in which the c-axis is aligned in a direction parallel to the substrate. If the c-axis direction is the horizontal direction, the in-plane rotation may be produced. The crystal structure of the h-BN film can be measured by a transmission type electron microscope (TEM) (see, for example, T.A. Friedmann et al., thin solid films, 237 (1994) 48-56). The content of h-BN in which the c-axis direction is parallel to the substrate is preferably 30 mol% or more and more preferably 70 mol% or more. It is considered that if the c-axis direction is made parallel to the substrate in the h-BN film, the polarizability of the entire film is reduced whereby the dielectric constant is reduced.

It is expected that a reduction in the number of bonds (NH) between nitrogen atom and hydrogen atom and bonds (BH) between boron atom and hydrogen atom, extension of the plane direction in the c-axis direction and making the c-axis direction parallel to the substrate respectively contribute to a reduction in the dielectric constant of the h-BN film. The dielectric constant can be more decreased by combining these measures.

Specific inductance of the h-BN film according to the present invention can be reduced more by introducing hydrogen by ion implantation to cause the disorder of the connectivity of molecules, enabling a further reduction in specific inductance. The disorder of the connectivity of molecules can be measured using a transmission type electron microscope (TEM) (see, for example, T.A. Friedmann et al., thin solid films, 237 (1994) 48-56). In order to lower the specific inductance, it is effective that the degree of the disorder of the connectivity is preferably a maximum of about 50 molecules and more preferably a maximum of about 15 molecules . It is considered that the polarizability of the entire film is more decreased than when no disorder of molecules is present and the dielectric constant is decreased by making the connectivity of molecules disordered.

Also, the h-BN film according to the present invention allows amorphous BN (α-BN) to be mingled by introducing hydrogen by ion implantation, making it possible to decrease the dielectric constant. The amount of amorphous BN present can be measured using a transmission type electron microscope (TEM) (see, for example, T.A. Friedmann et al., thin solid films, 237 (1994) 48-56). The amount of amorphous BN to be mingled is preferably 40 mol% or less.

Also, the h-BN film according to the present invention allows c-BN to be mingled by introducing hydrogen by ion implantation, making it possible to decrease the dielectric constant. The amount of c-BN present can be measured using a transmission type electron microscope (TEM) (see, for example, T.A. Friedmann et al., thin solid films, 237 (1994) 48-56). The amount of c-BN to be mingled is preferably 40 mol% or less.

Although α-BN and c-BN are allowed to coexist, it is preferable that the both be present in an amount of 40 mol% in total in the h-BN film.

It is considered that the polarization capability of the entire film is decreased and the dielectric constant is decreased by allowing α-BN and c-BN to coexist.

Next, an apparatus and a method for producing the h-BN film according to the present invention will be explained.

The ion deposition method used in the present invention means a deposition method involving the radiation of nitrogen ions or mixed ions of nitrogen and rare gas and the deposition of a boron supply source under vacuum. The vacuum meant here is one enabling deposition and a vacuum ranging between 10⁻³ and 10⁻⁸ Torr is usually used.

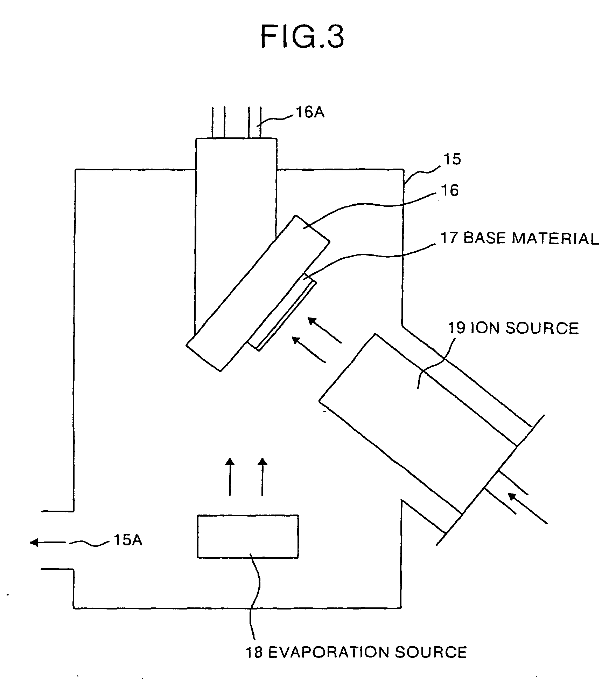

Fig. 3 shows an example of the apparatus used in the present invention for forming a BN film using an ion deposition method. The vacuum chamber 15 is a chamber which can keep a vacuum condition and is communicated with a vacuum source, though not shown, through an exhaust port 15A. The base material holder 16 is disposed in the vacuum chamber 15. This base material holder 16 is cooled by cooling water introduced from a cooling feed and drain pipe 16A to keep a base material 17 attached the holder 16 at a predetermined temperature. Mixed ions obtained by ionizing mixed gas of rare gas and nitrogen are allowed to impinge against the base material from an ion source 19 and at the same time, boron (B) from an evaporation source 18 is deposited on the base material 17. This process ensures that an h-BN film having a composition with a B/N ratio of 0.9 to 1.1 can be produced on the substrate.

The aforementioned rare gas may be argon or krypton. As the nitrogen supply source, nitrogen or the like having no bond between a nitrogen atom and a hydrogen atom is used in place of ammonia (NH₃) or the like having a bond between a nitrogen atom and a hydrogen atom. As to the ratio between the rare gas and nitrogen to be mixed, nitrogen is contained in the mixed gas in an amount by volume of 20% or more and preferably 50 to 90%. The mixed gas of rare gas and nitrogen is used to raise the dissociation efficiency of nitrogen. As the boron supply source for supplying vapor boron to the base material 17, a boron supply source having no bond between a boron atom and a hydrogen atom is preferably used instead of diborane (B₂H₆) having a bond between a boron atom and a hydrogen atom. Preferable examples of the boron supply source may include metal boron.

Examples of the ion source 19 include a Kaufmann type ion source and microwave discharge type ion source. As examples of the evaporation source 18, an electron beam evaporation source is given.

The temperature of the base material 17 is kept preferably at ambient temperature to 200 °C by cooling using cooling water introduced through the cooling feed and drain pipe 16A. Because in the present invention, the nitrogen supply source and the boron supply source containing neither BH bond nor NH bond are used, no hydrogen bond (BH and NH) is produced in the BN film to be formed and also the temperature of the base material can be made low, so that the deterioration of metal wirings is not caused by heat. Thus, the method of the present invention can be applied to a process of producing a metal wiring.

The present invention will be hereinafter explained in detail by way of examples, which, however, are not intended to be limiting of the present invention.

### Example 1:

An BN film manufacturing apparatus using an ion deposition method as shown in Fig. 3 was used. A p-type silicon substrate was set as a substrate 17 to a base material holder 16 in a vacuum chamber 15. Ions (flow rate = 5 sccm) obtained by mixing argon with nitrogen (N) in a ratio of 64:36 were allowed to impinge against the silicon substrate (substrate temperature: 200 °C) from a Kaufmann type ion source as an ion source 19 at an acceleration voltage of 0.5 kV and at the same time, boron (B) was supplied from an electron beam evaporation source as an evaporation source 18 at a rate of 0.5 angstroms/s to form an h-BN film having a composition with a B/N ratio of 1. The degree of vacuum in the vacuum chamber 1 during filming was set to 1.0 × 10⁻⁴ Torr.

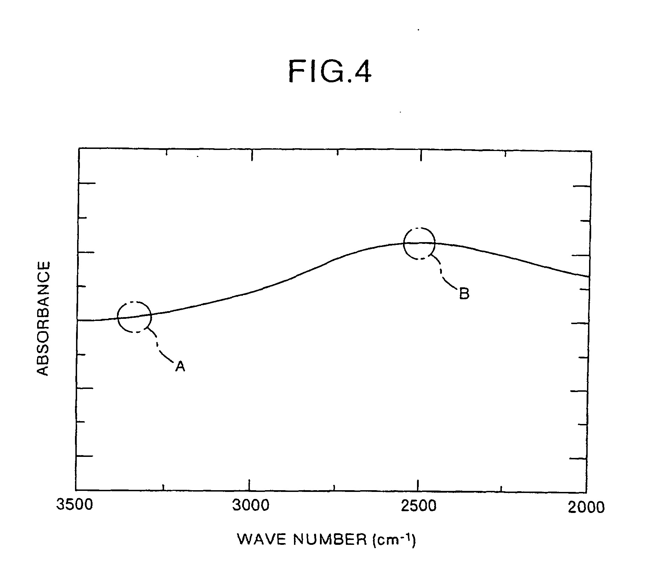

The results of the measurement of the resulting h-BN film by using an infrared absorption spectrometry (FTIR) is shown in Fig. 4. As is clear from Fig. 4, no NH bond (3340 cm⁻¹) is found in the region A of Fig. 4 and no BH bond (2520 cm⁻¹) is found in the region B of Fig. 4.

The specific inductance ε of the resulting h-BN film was calculated from the result of capacity-voltage (CV) measurement (see, for example, M.Z. Karim et. al., surface and coatings technology, 60 (1993) 502-505). The specific inductance ε was 2.4.

The section of the resulting h-BN film was observed by a transmission type electron microscope (TEM) to find that the spacing in the c-axis direction was extended to 3.73 angstrom from the usual spacing 3.3 2.5 angstroms. At this time, the c-axis direction of the h-BN was parallel to the silicon substrate.

### Example 2:

Another h-BN film was produced in the same manner as in Example 1. The resulting h-BN film was implanted with hydrogen ions in the condition that the energy was 15 keV and the amount to be implanted was 1×10¹⁶ cm⁻². After that, CV measurement was made to calculate the specific inductance to find that ε = 2.2. Also, the section of the resulting h-BN film was observed using a TEM to find that the spacing in the c-axis direction was extended to 3.73 angstroms from the usual spacing 3.3 2.5 angstroms. The periodicity of the crystal was less than about 60 angstroms and α-BN and c-BN coexisted. At this time, the c-axis direction of the h-BN was parallel to the silicon substrate.

In Examples 1 and 2, source gas containing no hydrogen bond was used since it excluded hydrogen and a source gas (nitrogen) was ionized and accelerated to provide energy. Therefore, the h-BN film could be produced at a substrate temperature as low as 200 °C. Also, the spacing of the h-BN film in the c-axis direction was extended to 3.7 angstroms from 3.3 angstroms and the c-axis direction of the h-BN film was parallel to the substrate. Thus, the specific inductive capacitor of the h-BN film was decreased to 2.4.

Also, hydrogen ions were introduced into the obtained h-BN film by ion implantation thereby causing the disorder of the crystal periodicity, making α-BN and c-BN coexist and further decreasing the specific inductance of the h-BN film to 2.2.

As aforementioned, the h-BN film according to the present invention is used as a layer dielectric film having a lower dielectric constant than a silicon oxide film (ε = 4 to 4.5), thereby enabling the production of a device which is more highly integrated.

Next, in second to fourth embodiments described below, a plasma CVD apparatus used in the present invention will be explained in detail.

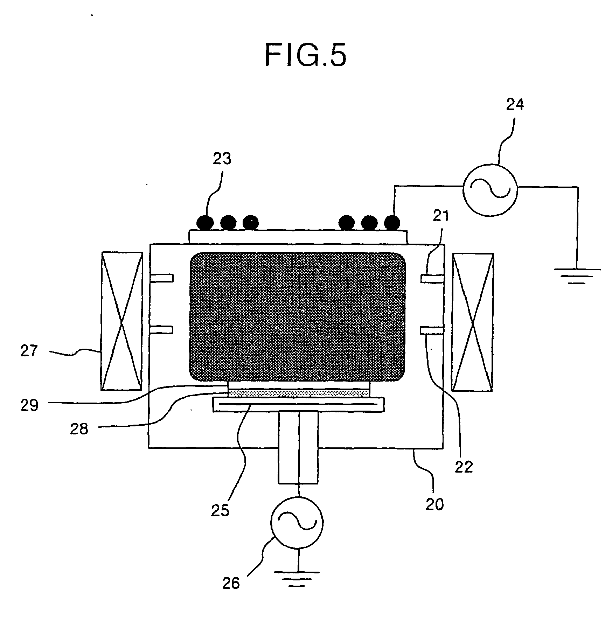

Fig. 5 is a view showing the structures of the second to fourth embodiments according to the present invention. In this figure, a plasma CVD apparatus for forming a multilayer film on a semiconductor device by utilizing plasma vapor excitation. This plasma CVD apparatus is a system in which raw gas consisting of elements constituting the thin film is supplied to a semiconductor wafer to form a desired thin film by a chemical reaction which is run either in a vapor phase or on the surface of the semiconductor device. Plasma discharge is used to excite gas molecules.

In Fig. 5, nozzles 21 and 22 for emitting the raw gas are disposed on the inside surface of a reaction vessel 20. From the nozzle 21, 100% N₂, 100% NH₃ or N₂+NH₃ are discharged as the raw gas supplied from a bomb (not shown) in a total flow rate of 100 to 1000 sccm. Also, from the nozzle 22, B₂H₆ diluted to a concentration of 5% or less with H₂, N₂, He, Ar or the like as the raw gas supplied from a bomb (not shown) was discharged in a total flow rate of 100 to 1000 sccm.

The RF electrode 23 is disposed on the top of the reaction vessel 20 and connected to a high frequency power source 24. A bias electrode 25 is disposed in the reaction vessel 20 in a manner that it faces the RF electrode 23 and connected to a high frequency power source 26. These RF electrode 23 and bias electrode 25 serve to generate an electric field. The RF power of the RF electrode 23 is 1 kW or more and the bias power of the bias electrode 25 is 0.5 kW or more.

A magnetic field coil 27 is wound around the reaction vessel 20 and works to generate a rotating horizontal magnetic field (10 to 300 gausses) . A semiconductor wafer 28 having a diameter of 12 inches is mounted on the bias electrode 25 in a manner that it lies at right angles to the above electric field. On the surface of the semiconductor wafer 28, a BN film 29 having a low specific inductance is formed by a process described later. Here, the BN film having a low dielectric constant means a protective film which is constituted of a boron source (B) : B₂H₆ or BCl₃ and a nitrogen source (N) : N₂ or NH₃, and has a low dielectric constant. It is to be noted that the magnetic field coil 27 is not essential.

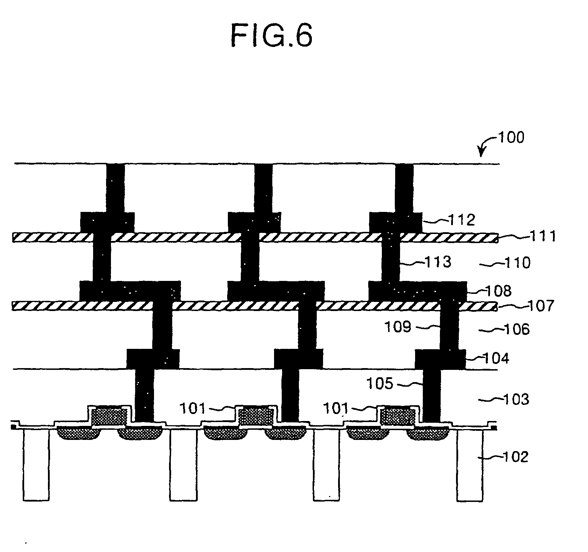

Fig. 6 is a view showing the structure of a semiconductor device 100 manufactured in the second to fourth embodiments. In the semiconductor device 100 shown in this figure, basic transistors 101, 101, ... are respectively insulated by an inter-elemental isolation film 102. Under-wiring dielectric film 103 such as BPSG (Boro-Phospho-Silicate-Glass) is formed on the surface of each basic transistor 101, 101, ....

The metal wiring 104 is formed on the surface of the under-wiring dielectric film 103 and connected to the basic transistor 101 through the inter-wiring metal 105 formed in a contact hole penetrating the under-wiring dielectric film 103. Moreover, an inter-wiring dielectric film 106 is formed on the surface of the under-wiring dielectric film 103 (metal wiring 104). The inter-wiring dielectric film 106 is composed of a material having a low specific inductance to decrease parasitic capacitance. On the surface of the inter-wiring dielectric film 106, a BN-film 107 having a low specific inductance as a protective film is formed.

The metal wiring 108 is formed on the surface of the BN film 107 having a low specific inductance and connected to the metal wiring 104 through an inter-wiring metal 109 formed in a contact hole penetrating the inter-wiring dielectric film 106 and the BN film 107 having a low specific inductance. Moreover, the inter-wiring dielectric film 110 is formed on the surface of the BN film 107 (metal wiring 108) having a low specific inductance. On the surface of the inter-wiring dielectric film 110, the BN film 111 having a low specific inductance as a protective film is formed. This inter-wiring dielectric film 110 is composed of a material having a low specific inductance to decrease parasitic capacitance.

The metal wiring 112 is formed on the surface of the BN film 111 having a low specific inductance and connected to the metal wiring 108 through an inter-wiring metal 113 formed in a contact hole penetrating the inter-wiring dielectric film 110 and the BN film 111 having a low specific inductance. The semiconductor device 100 is made to have a multilayer structure in this manner.

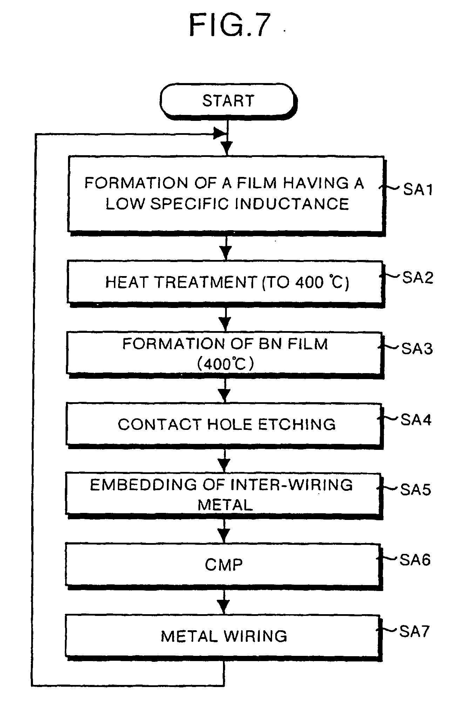

Next, a production process of the second embodiment will be explained with reference to a flowchart shown in Fig. 7. The process of forming the BN film 107 having a low specific inductance shown mainly in Fig. 6 is primarily explained hereinbelow. In this case, the explanations will be furnished on the premise that the structure up to the inter-wiring dielectric film 106 as shown in Fig. 6 has been formed on the semiconductor wafer 28 as shown in Fig. 5. However, the inter-wiring metal 109 has not been formed.

At step SA1 shown in Fig. 7, a film having a low specific inductance is formed on the surface of the semiconductor wafer 28 (inter-wiring dielectric film 106). Specifically, from the nozzle 21, 100% N₂, 100% NH₃ or N₂+NH₃ are emitted as the raw gas supplied from a bomb (not shown) in a total flow rate of 100 to 1000 sccm. Furthermore, from the nozzle 22, B₂H₆ which is diluted to a concentration of 5% or less with H₂, N₂, He, Ar or the like is emitted at a total flow rate of 100 to 1000 sccm. By the above process, the above raw gas is mixed in the reaction vessel 20 and a film having a low specific inductance is formed on the inter-wiring dielectric film 106.

At step SA2, such a heat treatment that the semiconductor wafer 28 in the reaction vessel 20 is heated to 300 to 400 °C by a heating unit (not shown) is carried out. By this heat treatment, the BN film 107 having a low specific inductance is formed on the surface of the inter-wiring dielectric film 106 at step SA3. The specific inductance of the BN film 107 having a low specific inductance is set to 2.2. Also, the BN film 107 having a low specific inductance basically has a hexagonal crystal structure and a composition with the ratio [B]/[N] = 1. Further, the film thickness of the BN film 107 having a low specific inductance is designed to be 20 to 100 nm enough to be effective as a protective film.

At step SA4, etching is carried out to form a contact hole in both of the BN film 107 having a low specific inductance and the inter-wiring dielectric film 106. At step SA5, the inter-wiring metal 109 is embedded in the formed contact hole. At step SA6, the surface is polished by CMP. At step SA7, the metal wiring 108 is formed on the surface of the BN film 107 having a low specific inductance. The process involving the steps including and in succession to the step SA1 is repeated to manufacture the semiconductor device 100 having a multi layer film structure shown in Fig. 6.

It is to be noted that the second embodiment may have a structure in which the dielectric films 103, 106 and 110 as shown in Fig. 6 are composed of the aforementioned boron source (B) and nitrogen source (N) and these layers are used as BN films having a low dielectric constant.

As aforementioned, in the second embodiment, the semiconductor wafer 28 is heated after the film having a low specific inductance is formed on the inter-wiring dielectric film 106 to form the BN film 107 having a low specific inductance on the surface of the inter-wiring dielectric film 106. Therefore, the resistance to oxygen plasma, mechanical strength, thermal-diffusion efficiency, moisture-absorption and permeation ability, heat resistance and barrier effect against the diffusion of impurities can be more improved than usual.

Furthermore, the formation of a film having a low specific inductance and the heat treatment can be carried out continuously in the reaction vessel 20 and therefore the process can be shortened.

In the second embodiment, an example in which the BN films 107 and 111 having a low specific inductance are formed in the reaction vessel 20. However, the inter-wiring dielectric films 106 and 110 may be formed in the reaction vessel 20. This case will be explained as a third embodiment hereinbelow.

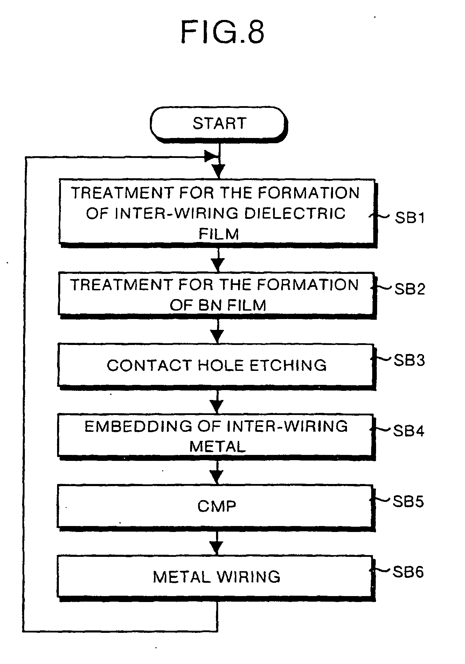

Production process of the third embodiment will be explained with reference to a flowchart shown in Fig. 8. A process of forming the inter-wiring dielectric film 106 and the BN film 107 having a low specific inductance shown mainly in Fig. 6 is primarily explained hereinbelow. In this case, the explanations will be furnished on the premise that the structure up to the under-wiring dielectric film 103 and the metal wiring 104 as shown in Fig. 6 has been formed on the semiconductor wafer 28 as shown in Fig. 5.

At step SB1 shown in Fig . 8, the inter-wiring dielectric film 106 is formed on the surface (under-wiring dielectric film 103 and metal wiring 104) of the semiconductor wafer 28 in the reaction vessel 20 by the well known CVD method. At step SB2, the BN film 107 having a low specific inductance is formed on the surface of the inter-wiring dielectric film 106 through the aforementioned steps SA1 to SA3 (see Fig. 7).

Steps SB3 to SB6 are the same as the steps SA4 to SA7 (see Fig. 7), therefore, their explanation will be omitted. The process involving the steps including and in succession to the step SB1 is repeated to manufacture the semiconductor device 100 having a multilayer film structure as shown in Fig. 6.

As aforementioned, according to the third embodiment, the formation of the inter-wiring dielectric film 106 and the formation of the BN film 107 having a low specific inductance can be carried out continuously in the reaction vessel 20 and therefore the process can be more shortened.

In the second embodiment, an example in which the BN films 107 and 111 having a low specific inductance are formed in the reaction vessel 20. However, an operation of making the inter-wiring dielectric films 106 and 110 porous may be carried out in the reaction vessel 20. This case will be explained as a fourth embodiment hereinbelow.

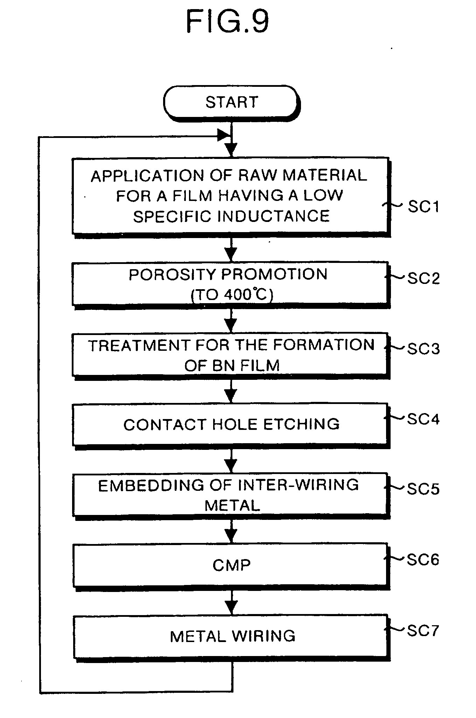

Production process of the fourth embodiment will be explained with reference to a flowchart shown in Fig. 9. A process of making the inter-wiring dielectric film 106 porous and a process of forming the BN film 107 having a low specific inductance shown mainly in Fig. 6 are primarily explained hereinbelow. In this case, the explanations will be furnished on the premise that the structure up to the inter-wiring dielectric film 106 as shown in Fig. 6 has been formed on the semiconductor wafer 28 as shown in Fig. 5. However, the inter-wiring metal 109 has not been formed.

At step SC1 shown in Fig.9, a film having a low specific inductance is formed on the surface (inter-wiring dielectric film 106) of the semiconductor wafer 28 in the same manner as in the step SA1 (see Fig. 7). At step SC2, the inter-wiring dielectric film 106 is made porous by using a well-known porosity-promoting method. This step ensures that the density of the inter-wiring dielectric film 106 is decreased thereby lowering the specific inductance of the film 106.

At step SC3, the BN film 107 having a low specific inductance is formed on the surface of the inter-wiring dielectric film 106 in the same manner as in the steps SA2 and SA3 (see Fig. 7). Steps SC4 to SC7 are the same as the steps SA4 to SA7 (see Fig. 7), therefore, their explanation will be omitted. The process involving the steps including and in succession to the step SC1 is repeated to manufacture the semiconductor device 100 having a multi layer film structure as shown in Fig. 6.

As a forementioned, according to the fourth embodiment, the inter-wiring dielectric film 106 is made porous and the BN film 107 having a low specific inductance is formed on the surface of the inter-wiring dielectric film 106. Therefore, the shortening of the process can be attained. Moreover, the interface characteristics which are the weak points of a porous film can be improved and the deterioration of film qualities and high hygroscopic properties caused by filming, etching and ashing can be limited.

As outlined above, according to the present invention, a semiconductor wafer is heated after a film having a low specific inductance is formed on the surface of an inter-wiring dielectric film to form a protective film on the surface of the inter-wiring dielectric film. Therefore, the invention produces such an effect that the resistance to oxygen plasma, mechanical strength, thermal-diffusion efficiency, moisture-absorption and permeation ability, heat resistance and barrier effect against the diffusion of impurities can be more improved than usual.

Furthermore, the formation of a film having a low specific inductance and heat treatment can be carried out continuously. Therefore, the invention produces such an effect that the process can be shortened.

According to the present invention, the formation of an inter-wiring dielectric film and the formation of a protective film are carried out continuously. The present invention therefore produces such an effect that the process can be more shortened.

Furthermore, an inter-wiring dielectric film is made porous by using a porosity-promoting unit and a protective film is formed on the surface of the inter-wiring dielectric film. Therefore, the present invention produces such an effect that the shortening of the process can be attained, the interface characteristics which are the weak points of a porous film can be improved and the deterioration of film qualities and high hygroscopic properties caused by filming, etching and ashing can be limited.

Although the invention has been described with respect to a specific embodiment for a complete and clear disclosure, the appended claims are not to be thus limited but are to be construed as embodying all modifications and alternative constructions that may occur to one skilled in the art which fairly fall within the basic teaching herein set forth.

## Claims

1. A hexagonal boron nitride film wherein the total number of the bonds between nitrogen and hydrogen atoms and between boron and hydrogen atoms is 4 mol% or less.

2. A hexagonal boron nitride film according to claim 1 wherein the hexagonal boron nitride film has a specific inductance of 3.0 or less.

3. A hexagonal boron nitride film according to claim 1 wherein a spacing in the c-axis direction is extended by 5 to 30% from 3.3 angstroms but the extension of a spacing in the a-axis direction is limited within 5% from 2.2 angstroms, and wherein the direction of the c-axis is parallel to a substrate.

4. A layer dielectric film comprising a hexagonal boron nitride film according to claim 1.

5. The layer dielectric film according to claim 4 wherein the hexagonal boron nitride contains 40 mol% or less of amorphous boron nitride, 40 mol% or less of cubic boron nitride or 40 mol% or less of amorphous boron nitride and cubic boron nitride.

6. A method of producing a hexagonal boron nitride film according to claim 1 by using an ion deposition method involving the radiation of a mixed ion consisting of a nitrogen ion or nitrogen and rare gas and the deposition of a boron supply source under vacuum, the method comprising using a nitrogen supply source and a boron supply source containing no bond with a hydrogen atom.

7. The method of producing a hexagonal boron nitride film according to claim 6, wherein the filming temperature of said substrate is designed to be 200 °C or less.

8. The method of producing a hexagonal boron nitride film according to claim 6, the method further comprising a step of introducing hydrogen by ion implantation.

## Patentansprüche

1. Hexagonale Bornitridschicht, worin die Gesamtzahl der Bindungen zwischen Stickstoff- und Wasserstoffatomen und zwischen Bor- und Wasserstoffatomen 4 mol-% oder weniger beträgt.

2. Hexagonale Bornitridschicht gemäss Anspruch 1, worin die hexagonale Bornitridschicht eine spezifische Induktivität von 3,0 oder weniger aufweist.

3. Hexagonale Bornitridschicht gemäss Anspruch 1, worin der Abstand in Richtung der c-Achse von 3,3 Å um 5-30 % verlängert ist, die Verlängerung des Abstands in Richtung der a-Achse von 2,2 Å jedoch auf innerhalb von 5 % beschränkt ist, und worin.die Richtung der c-Achse parallel zum Substrat verläuft.

4. Dielektrische Schichtlage, die eine hexagonale Bornitridschicht gemäss Anspruch 1 umfasst.

5. Dielektrische Schichtlage gemäss Anspruch 4, worin das hexagonale Bornitrid 40 mol-% oder weniger amorphes Bornitrid, 40 mol-% oder weniger kubisches Bornitrid oder 40 mol-% oder weniger amorphes Bornitrid und kubisches Bornitrid enthält.

6. Verfahren zur Herstellung einer hexagonalen Bornitridschicht gemäss Anspruch 1 unter Verwendung eines Ionenabscheidungsverfahrens, das die Bestrahlung mit gemischten Ionen, bestehend aus Stickstoffionen oder Stickstoff und Edelgas, und die Abscheidung einer Borversorgungsquelle im Vakuum beinhaltet, wobei das Verfahren die Verwendung einer Stickstoffversorgungsquelle und einer Borversorgungsquelle umfasst, die keine Bindungen zu Wasserstoffatomen enthalten.

7. Verfahren zur Herstellung einer hexagonalen Bornitridschicht gemäss Anspruch 6, worin die Schichtbildungstemperatur des Substrats so ausgelegt ist, dass sie 200°C oder weniger beträgt.

8. Verfahren zur Herstellung einer hexagonalen Bornitridschicht gemäss Anspruch 6, worin das Verfahren ferner einen Schritt der Einführung von Wasserstoff durch Ionenimplantation umfasst.

## Revendications

1. Film de nitrure de bore hexagonal dans lequel le nombre total des liaisons entre les atomes d'azote et d'hydrogène et entre les atomes de bore et d'hydrogène est de 4 % en moles ou moins.

2. Film de nitrure de bore hexagonal selon la revendication 1, dans lequel le film de nitrure de bore hexagonal a une inductance spécifique de 3,0 ou moins.

3. Film de nitrure de bore hexagonal selon la revendication 1, dans lequel un espace dans la direction de l'axe c est étendu de 5 à 30 % par rapport à 3,3 angströms, mais l'extension d'un espace dans la direction de l'axe a est limitée à l'intérieur de 5 % par rapport à 2;2 angströms, et dans lequel la' direction de l'axe c est parallèle à un substrat.

4. Film diélectrique en couche comprenant le film de nitrure de bore hexagonal selon la revendication 1.

5. Film diélectrique en couche selon la revendication 4, dans lequel le nitrure de bore hexagonal contient 40 % en moles ou moins de nitrure de bore amorphe, 40 % en moles ou moins de nitrure de bore cubique ou 40 % en moles ou moins de nitrure de bore amorphe et de nitrure de bore cubique.

6. Procédé de production d'un film de nitrure de bore hexagonal selon la revendication 1, en utilisant un procédé de dépôt d'ions mettant en jeu le rayonnement d'un ion mixte constitué d'un ion d'azote ou d'azote et de gaz rare et le dépôt d'une source d'alimentation de bore sous vide, le procédé comprenant l'utilisation d'une source d'alimentation d'azote et d'une source d'alimentation de bore ne contenant pas de liaison avec un atome d'hydrogène.

7. Procédé de production d'un film de nitrure de bore hexagonal selon la revendication 6, dans lequel la température de formation de film dudit substrat est conçue pour être de 200°C ou moins.

8. Procédé de production d'un film de nitrure de bore hexagonal selon la revendication 6, le procédé comprenant en outre une étape d'introduction d'hydrogène par implantation d'ions.
